Europäisches Patentamt

European Patent Office

Office européen des brevets

(19)

(11) Veröffentlichungsnummer: **0 007 644**
**B1**

(12) **EUROPÄISCHE PATENTSCHRIFT**

(45) Veröffentlichungstag der Patentschrift:
26.08.81

(51) Int. Cl.³: **F 21 K 2/00**, G 02 F 1/13

(21) Anmeldenummer: **79102731.1**

(22) Anmeldetag: **31.07.79**

(54) Vorrichtung zur Sammlung von Licht und Verfahren zur Herstellung einer solchen Vorrichtung.

(30) Priorität: **02.08.78 DE 2833914**

(43) Veröffentlichungstag der Anmeldung:
**06.02.80 Patentblatt 80/3**

(45) Bekanntmachung des Hinweises auf die Patenterteilung:
**26.08.81 Patentblatt 81/34**

(84) Benannte Vertragsstaaten:
**AT CH FR GB IT NL SE**

(56) Entgegenhaltungen:
DE-A-2 426 919
FR-A-2 404 347
GB-A-1 386 714
GB-A-2 003 290
US-A-4 058 639

ELEKTRONIK, Vol. 26, Nr.6, Juni 1977,
W. GREUBEL et al.: «Fluoreszenzaktivierte
Display FLAD», Seiten 55–56

ELEKTROTECHNIK, Vol. 59, Nr. 11, Juni 1977,
«Leuchtstark, farbig und konstrastreich»,
Seite 31

COMPUTER DESIGN, Vol. 16, Nr. 10, 1, 7
Oktober 1977,

(73) Patentinhaber: **SIEMENS AKTIENGESELLSCHAFT Berlin
und München, Postfach 22 02 61, D-8000 München 22 (DE)**

(72) Erfinder: **Greubel, Waldemar, Dipl.-Phys.,
Johanneskirchnerstrasse 25, D-8000 München 81 (DE)**
Erfinder: **Quella, Ferdinand, Dr. Dipl.-Ing.,
Drygalski-Allee 118, D-8000 München 71 (DE)**

(56) Entgegenhaltungen:
«Fluorescence activated LCD$_5$ may serve
in low light conditions», Seiten 34, 38

ELECTRONICS, Vol. 50, Nr. 25, Dezember 1977,
M. BECHTLER et al.: «Dim light is no
turnoff for fluorescence activated LCD»,
Seiten 113–116

Vorrichtung zur Sammlung von Licht und Verfahren zur Herstellung einer solchen Vorrichtung

Die Erfindung betrifft eine Vorrichtung gemäss dem Oberbegriff des Anspruchs 1. Ein solcher Kollektor ist bereits in mehreren Ausführungen bekannt und kann beispielsweise zum Einfangen von Sonnenenergie (P.B. Mauer und G.T. Turechek, Research Disclosure 29 (1975) 20, DE-A-26 20 115 oder A. Götzberger und W. Greubel, Appl. Phys. 14 (1977) 123), zur optischen Übertragung von Nachrichten (DE-A-27 42 899), zur Bildaufhellung passiver Displays (DE-A-25 54 226 oder W. Greubel und G. Baur, Electronik 6 (1977) 55) oder zur Erhöhung der Empfindlichkeit von Szintilatoren (G. Keil, Nucl. Instr. and Meth. 87 (1970) 111) verwendet werden.

Trifft Licht auf eine Fluoreszenzplatte, so wird der im Anregungsspektrum des Fluoreszenzstoffes liegende Anteil von den Fluoreszenzzentren absorbiert; der übrige Lichtanteil durchsetzt die Fluoreszenzplatte ungestört. Die absorbierte Strahlung wird – zu längeren Wellenlängen hin verschoben und räumlich ungerichtet – reemittiert. Von diesem Fluoreszenzlicht wird der weit überwiegende Teil durch (Total-)Reflexionen an den Plattengrenzflächen im Inneren der Trägerplatte fortgeleitet, bis er an bestimmten Auskoppelbereichen mit erhöhter Intensität austritt.

Die bisher mit Fluoreszenzplatten erzielten Wirkungsgrade bleiben noch immer deutlich hinter den theoretisch möglichen Werten zurück, und zwar vor allem deshalb, weil das Emissionsspektrum mit dem Absorptionsspektrum überlappt und daher die Fluoreszenzstrahlung in der Platte eine endliche Absorptionslänge hat. Besonders unbefriedigend ist dabei, dass sich diese «Selbstabsorption» gerade bei Fluoreszenzkörpern mit grosser Sammelfläche besonders ungünstig auswirkt.

Man weiss bereits seit längerem, dass bei vielen organischen Fluoreszenzstoffen das Emissionsband gegenüber dem Anregungsband zu niedrigeren Frequenzen hin verschoben wird, wenn diese Farbstoffe in einer Flüssigkeit mit einer starken Orientierungspolarisation gelöst werden. Eine solche Rotverschiebung tritt auf, wenn das fluoreszierende Molekül in einem Grund- und Anregungszustand verschiedene Dipolmomente ($\mu_g \neq_a$) hat und wenn die Polarisation der Umgebung, die während des Absorptionsprozesses unverändert bleibt, während der Existenz des Anregungszustandes ihren neuen, durch $\mu_a$ bestimmten Gleichgewichtszustand erreichen kann (E. Lippert, Z. Elektrochem. Ber. Bunsenges, phys. Chem. 61 (1957) 962. Ist $\mu_a \gg \mu_g$, dann beobachtet man eine Rotverschiebung der Emission bei im wesentlichen unveränderter Lage der Absorption. Eine Blauverschiebung der Absorption bei im wesentlichen unveränderter Lage der Emission tritt ein, wenn $\mu_g \gg \mu_a$.

Fluoreszenzkörper sollen jedoch nach Möglichkeit aus einem festen Trägermaterial bestehen. Denn feste Träger kann man, insb. wenn es organische Kunststoffe sind, mit relativ geringem Aufwand herstellen und verarbeiten, ein Vorzug, der insb. bei Massenfertigungen stark ins Gewicht fällt.

Dass auch in Festkörper-Lösungen die erwünschte Bandtrennung von der Dielektrizitätskonstanten ($\varepsilon$) des Lösungsmittels abhängt und hierbei die Dipolunterschiede im Grund- und angeregten Zustand eine wichtige Rolle spielen, wird bereits in der zitierten Arbeit von Götzberger und Greubel erwähnt (vergl. den dortigen Abschnitt 3.3)). Weiterführende Untersuchungen der angedeuteten Zusammenhänge, insb. aber Hinweise über Möglichkeiten, wie man feste Fluoreszenzkörper auf Kunststoff-Basis mit hoher Orientierungspolarisation in der Praxis verwirklichen könnte, stehen noch aus. Die derzeit verfügbaren hochtransparenten Kunststoffe haben in aller Regel nur geringe $\varepsilon$-Werte, da es bislang vornehmlich darum ging, gute elektrische Isolationseigenschaften zu erzielen.

Um diese Lücke zu schliessen, wird erfindungsgemäss die im Patentanspruch 1 angegebene Merkmalskombination vorgeschlagen.

Überraschenderweise hat sich herausgestellt, dass sich in ausgewählte, durchaus bekannte Kunststoffe bestimmte flüssige polare organische Zusätze einlagern lassen, derart, dass eine einheitliche feste Phase entsteht, in der die Zusätze dennoch ihren Flüssigkeitscharakter in gewisser Weise beibehalten und beweglich bleiben. In einen solchen Festkörper eingebettete fluoreszierende Partikel finden jeweils eine Umgebung vor, in der sie eine Orientierungspolarisation mit hinreichend kurzen Relaxationszeiten hervorrufen können. Diese lokal induzierten Polarisationen streuen dabei, wie sich ausserdem gezeigt hat, nur wenig um einen Mittelwert, so dass im Ergebnis das Absorptions- und das Emissionsband nicht nennenswert verbreitert sind und somit nicht nur die beiden Bandmaxima gegeneinander verschoben werden, sondern auch die Bandüberlappung deutlich abnimmt. Dies gilt für die beiden Fälle $\mu_a \gg \mu_g$ und $\mu_g \gg \mu_a$.

Da der Zusatz in der Trägermatrix gleichmässig verteilt ist und somit im Fluoreszenzkörper eine ortsunabhängige Orientierungspolarisierbarkeit herrscht, lässt sich die vorgeschlagene Vorrichtung im wesentlichen auch über die Dielektrizitätskonstante der Lichtfalle charakterisieren: Der $\varepsilon$-Wert des Fluoreszenzkörpers muss bis hin zu Frequenzen in der Grössenordnung der reziproken Lebensdauer des angeregten Zustandes eines Fluoreszenzzentrums einen hohen Wert haben. Geeignete Wertebereiche sind im Anspruch 2 angegeben.

Als Träger-Kunststoffe eignen sich vor allem Polyacrylate und Polymethacrylate. Daneben kommen aber auch andere Polymere wie Polystyrole in Frage. Denkbar sind auch Copolymere mit Methacrylaten und Styrolen als Hauptkomponente.

Die polaren Zusätze bestehen aus monomeren oder polymeren, vorwiegend hochsiedenden Alkoholen. Diese Alkohole können entweder aliphatischer oder aromatischer Natur sein. Unter den aliphatischen Alkoholen bieten sich vor allem Glykole wie Äthylenglykol ($\varepsilon = 37,7$; Siedepunkt bei ca. 197 °C), Bi-, Tri-, Oligo- oder Poly-Äthylenglykol an. Ein Beispiel für einen geeigneten aromatischen Alkohol ist Benzylalkohol ($\varepsilon = 13,1$, Siedepunkt bei ca. 205 °C). Auch Mischungen verschiedener Alkohole lassen sich verwenden. Ein Beispiel für einen chemisch gebundenen Alkohol ist Methacrylsäure-(2-hydroxypropyl)ester.

Die Zusätze können neben Alkoholen auch aus Nitrilen bestehen. Beispiel: Methacrylsäure-(2-nitrilopropyl)ester. Eine dritte als Zusatz geeignete Gruppe sind die ionogenen oder nichtionogenen Seifen, wie etwa Polyoxyäthylensorbitanmonolaurat.

Schliesslich lassen sich auch andere hochsiedende polare Lösungsmittel als Zusatz heranziehen, die in hoher Konzentration mit dem Polymeren verträglich sind. Ein solches Lösungsmittel ist Phtalsäuredibutylester.

Die genannten Ausgangsstoffe lassen eine Vielzahl von Kombinationen Polymer/Zusatz zu, die, wie durch Versuche bestätigt werden konnte, alle wichtigen Bedingungen erfüllen, die an das Fluoreszenzkörpermaterial gestellt werden müssen. Die wichtigsten Forderungen seien im folgenden aufgezählt:

Das Mischungsprodukt muss extrem transparent sein, ohne dass hierzu eine aufwendige Reinigung der Ausgangsprodukte erforderlich wäre; es hat thermisch und fotochemisch stabil zu sein; seine Mischungskomponenten müssen miteinander verträglich sein; die Mischung sollte sich bequem in beliebige Körperformen bringen lassen und im Endzustand über eine ausreichende Härte und Formbeständigkeit verfügen. Der polare Zusatz darf den Ausgangskunststoff nicht anlösen und muss ein gutes Lösungsmittel für den Fluoreszenzstoff sein; er soll die Quantenausbeute der Fluoreszenz nicht negativ beeinflussen; seine chemische Reaktionsfähigkeit darf nur sehr gering sein.

Der Fluoreszenzkörper einer erfindungsgemässen Vorrichtung kann auf verschiedene Weise hergestellt werden. Am rationellsten arbeitet man mit einem Spritzgussverfahren oder einer Extrudiertechnik oder aber man vergiesst den Körper. Dabei können die polaren Zusätze entweder mit einem unvernetzten (thermoplastischen) Polymeren, etwa in einem Extruder, gemischt werden; oder man mischt die Zusätze mit dem Monomeren und polymerisiert anschliessend die Mischung. Stellt man den Körper durch eine Giesstechnik her, dann braucht das Polymer nicht thermoplastisch zu sein, es kann also, wie dies bei Giessharzen der Fall ist, bei der Polymerisation vernetzen.

Einige wenige Polymer/Zusatz-Paarungen mischen sich zwar bei höheren Temperaturen gut, neigen aber beim langsamen Abkühlen dazu, in einer oder beiden Komponenten teilweise auszukristallisieren. Dem kann entgegengewirkt werden, indem man die Mischung von hoher Temperatur rasch auf niedrige Temperaturen bringt, so dass ein amorpher Glaszustand eingefroren wird. Ein solcher Abschreckungsprozess vollzieht sich beispielsweise automatisch beim Verarbeiten auf Spritzgussmaschinen, wo die Form meist bei einer Temperatur um ca. 60 °C gehalten wird.

Die in der geschilderten Weise hergestellten Endprodukte liegen in folgenden Modifikationen vor: Es sind entweder thermoplastische Kunststoffe mit polaren organischen Zusätzen in gelöster oder chemisch gebundener Form oder aber vernetzte thermoplastische Kunststoffe mit polaren organischen Zusätzen, die ebenfalls gelöst oder chemisch gebunden sind.

Die Erfindung soll nun in Verbindung mit den Figuren der beigefügten Zeichnung näher erläutert werden. Es zeigen:

Fig. 1 eine erfindungsgemässe Sammelvorrichtung, in einem schematisierten Seitenschnitt;

Fig. 2 in einem Diagramm die Grösse $\triangle f$ aus der Formel (1) als Funktion der relativen Dielektrizitätskonstanten $\varepsilon$;

Fig. 3 die Absorptions- und Emissionsspektren eines Fluoreszenzstoffes, der im Vergleich einmal in einem Fluoreszenzkörper einer erfindungsgemässen Vorrichtung und zum anderen im reinen Trägermaterial beziehungsweise im reinen Zusatz gelöst ist.

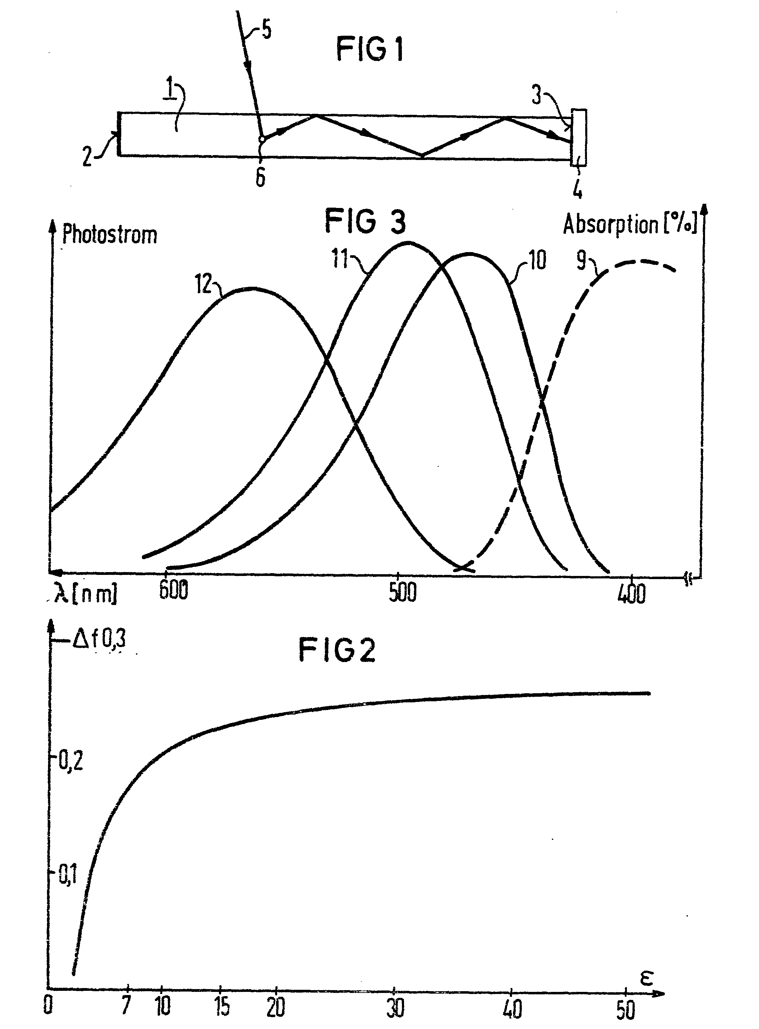

Die Lichtsammelvorrichtung gemäss Fig. 1 dient als Sonnenkollektor und enthält im einzelnen eine Fluoreszenzplatte 1, die an drei ihrer vier Schmalseiten jeweils mit einer Reflexionsschicht 2 versehen ist und an ihrer vierten Schmalseite (Lichtaustrittsseite 3) eine Solarzelle 4 trägt. In der Figur ist der typische Weg eines im Anregungsspektrum der fluoreszierenden Partikel liegenden Sonnenstrahls eingezeichnet: Der mit 5 bezeichnete Strahl wird von einem Fluoreszenzzentrum 6 im Inneren der Fluoreszenzplatte 1 absorbiert, reemittiert und mittels Totalreflexionen durch die Lichtaustrittsseite 3 auf die Solarzelle 4 geführt.

Wie bereits erwähnt, sollte die Dielektrizitätskonstante des Fluoreszenzkörpers möglichst grosse Werte haben, und zwar bei Frequenzen im Bereich der reziproken Lebensdauer des angeregten Fluoreszenzzentrums ($\approx 10^8$ Hz). Welche $\varepsilon$-Werte bereits einen deutlichen Verschiebungseffekt bringen, lässt sich folgendermassen näherungsweise ermitteln.

Für flüssige Lösungen hat Lippert anhand eines einfachen Modells für die Wellenzahldifferenz $\triangle v_{0-0}$ der O–O-Übergänge in Absorption und Emission folgende Beziehung hergeleitet

$$\triangle v_{0-0} \sim \triangle f \, (\mu_a - \mu_g)^2 \qquad (1)$$

$$\text{mit } \triangle f = \frac{\varepsilon - 1}{2\varepsilon + 1} - \frac{n^2 - 1}{2n^2 + 1} \qquad (2),$$

wobei $\varepsilon$ die Dielektrizitätskonstante bei einer Frequenz von der Grössenordnung der reziproken Lebensdauer des angeregten Fluoreszenzstoffzustandes ist, $n$ der Brechungsindex des Körpers bei einer Frequenz im sichtbaren Bereich bedeutet und $\mu_g$ bzw. $\mu_a$ für die Dipolmomente im Grund- bzw. Anregungszustand des fluoreszierenden Moleküls stehen. Formel (1) gilt unter der Annahme, dass während des Absorptionsprozesses ($\approx 10^{-15}$ sec) die Elektronenpolarisation der Dipolmomentänderung praktisch trägheitslos folgen kann, die Orientierungspolarisation der Umgebung dagegen unverändert bleibt, und dass während der Existenz des angeregten Zustandes ($\approx 10^{-9}$ sec) die Umgebung ihren thermodynamischen Gleichgewichtszustand voll ausbilden kann. Der Ausdruck (2) stellt dabei die Differenz der dielektrischen Wechselwirkungsenergie von Gesamtpolarisation und Verschiebungspolarisation dar, enthält also nur die Orientierungspolarisation. Damit ist $\triangle f$ ein Mass für die Polarität des Lösungsmittels.

Trägt man den $\triangle f$-Wert gegen die Dielektrizitätskonstante auf und legt man einen mittleren Brechungsindex von $n = 1,5$ für sichtbares Licht zugrunde, dann zeigt sich, dass $\triangle f$ zunächst sehr steil mit $\varepsilon$ ansteigt und dann langsam einem Grenzwert zustrebt. Dabei ist das Fluoreszenzband bereits dann beträchtlich gegen das Anregungsband zum Roten hin verschoben, wenn man $\varepsilon$-Werte zwischen 7 und 15 für das Lösungsmittel erreicht.

Diese Ergebnisse lassen sich in etwa auf die vorliegenden festen Fluoreszenzkörper übertragen, da auch hier – zumindest in der direkten Nachbarschaft der einzelnen Fluoreszenzzentren – vergleichbare Verhältnisse geschaffen sind. Versuche haben gezeigt, dass man vielfach schon mit $\varepsilon$-Werten von mindestens 5 die störende Selbstabsorption ausschalten kann.

Eine derart hohe Dielektrizitätskonstante des Fluoreszenzkörpers verlangt einen ausreichend hohen Zusatz-Anteil. Um einen Anhaltspunkt für die erforderliche Zusatzkonzentration zu erhalten, seien im folgenden wiederum zunächst die einfacheren Verhältnisse bei flüssigen Lösungen betrachtet.

Der $\varepsilon$-Wert einer flüssigen Mischung aus zwei Komponenten ist in grober Näherung

$$\varepsilon = (c-1)\varepsilon_1 + c\varepsilon_2 \qquad (3),$$

wobei $\varepsilon_1$ und $\varepsilon_2$ die Dielektrizitätskonstanten der Komponenten 1 bzw. 2 sind und c für die relative Konzentration der Komponente 2 steht. Nach Gleichung (3) steigt $\varepsilon$ linear mit der relativen Konzentration des polaren Zusatzes an. Formel (3) ist allerdings für Fluoreszenzkörper der vorgeschlagenen Zusammensetzung nur begrenzt gültig; die Grösse der Orientierungspolarisation, um die es hier ausschliesslich geht, hängt bekanntlich auch von der Viskosität ab. Und da im vorliegenden Fall ein hochviskoser Kunststoff mit einer relativ niedrigviskosen Flüssigkeit gemischt wird und sich somit die Viskosität mit dem Mischungsverhältnis ändert, wird $\varepsilon$ sicherlich in komplizierterer Form von der Konzentration c der zugemischten polaren Substanz abhängen. Formel (3) gibt also nur einen Hinweis auf den erforderlichen Konzentrationsbereich. Aus Versuchsreihen konnte ermittelt werden, das sich die günstigsten Resultate dann einstellen, wenn man den Gewichtsanteil des polaren Zusatzes zwischen 20 und 60 Gew.% wählt.

In Fig. 3 sind die Ergebnisse eines Versuches dargestellt, bei dem ein bestimmter Farbstoff in Polymethylmethacrylat (PMMA) allein, in Triäthylenglykol allein und in einer für die vorgeschlagene Vorrichtung geeigneten Mischung aus PMMA und 17 Gew.% Triäthylenglykol gelöst wurde. In der Darstellung sind die jeweiligen Absorptionsspektren, die sich als praktisch unveränderlich herausgestellt haben, durch eine gemeinsame Kurve (gestrichelte Kurve 9) wiedergegeben. Die ausgezogenen Kurven entsprechen den drei verschiedenen Emissionsspektren (Kurve 10 gehört zur PMMA-Lösung, Kurve 11 zur Gemisch-Lösung und Kurve 12 zur Glykol-Lösung). Dem Diagramm entnimmt man, dass sich das Emissionsspektrum mit zunehmender Polarität zu grösseren Wellenlängen hin verschiebt, von blaugrüner Fluoreszenz in PMMA zu grüner in der Mischung bis zu gelber Fluoreszenz im polaren flüssigen Zusatz allein.

Die Erfindung ist nicht nur auf die ausführlich geschilderten Ausführungsbeispiele beschränkt. Insbesondere kann man den Fluoreszenzkörper auch anders als streng plattenförmig gestalten, wenn man nur dafür sorgt, dass die Lichtfallenwirkung aufgrund von Totalreflexionen gewahrt bleibt. Geeignete Körperausbildungen sind beispielsweise in der DE-A-27 24 748 zu finden.

## Patentansprüche

1. Vorrichtung zur Sammlung von Licht, mit einem als Lichtfalle wirkenden, vorzugsweise plattenförmig ausgebildeten Körper («Fluoreszenzkörper»), der aus einem festen polymerisierten Kunststoff-Träger besteht, fluoreszierende Partikel enthält und mit mindestens einem Lichtaustrittsfenster versehen ist, dadurch gekennzeichnet, dass die fluoreszierenden Partikel (6) endliche Dipolmomente mit unterschiedlichen Werten im Grundzustand und im angeregten Zustand haben und dass im Kunststoff-Träger ein polarer organischer Zusatz gleichmässig verteilt ist, der um die fluoreszierenden Partikel (6) jeweils eine Umgebung mit einer Orientierungspolarisation schafft, wobei sich die Umgebung derart rasch umorientieren kann, dass sie während des Anregungszustandes des fluoreszierenden Partikels (6) praktisch vollständig ihr thermodynamisches Gleichgewicht erreicht.

2. Vorrichtung nach Anspruch 1, dadurch gekennzeichnet, dass der Fluoreszenzkörper bei einer Frequenz, die etwa der reziproken Lebensdauer des Anregungszustandes des fluoreszierenden Partikels entspricht, eine relative Dielektrizitätskonstante zwischen 5 und 20, insbesondere zwischen 7 und 15, hat.

3. Vorrichtung nach Anspruch 1 oder 2, dadurch gekennzeichnet, dass der Gewichtsanteil des Zusatzes, bezogen auf das Gewicht des gesamten Fluoreszenzkörpers, zwischen 20 und 60 Gew.%, insbesondere zwischen 30 und 50 Gew.%, liegt.

4. Vorrichtung nach einem der Ansprüche 1 bis 3, dadurch gekennzeichnet, dass der Zusatz im Kunststoff-Träger gelöst oder chemisch gebunden ist.

5. Vorrichtung nach einem der Ansprüche 1 bis 4, dadurch gekennzeichnet, dass der Kunststoff-Träger vernetzt oder unvernetzt ist.

6. Vorrichtung nach einem der Ansprüche 1 bis 5, dadurch gekennzeichnet, dass der Kunststoff-Träger ein Polyacrylat ist.

7. Vorrichtung nach einem der Ansprüche 1 bis 5, dadurch gekennzeichnet, dass der Kunststoff-Träger ein Polymethacrylat ist.

8. Vorrichtung nach einem der Ansprüche 1 bis 5, dadurch gekennzeichnet, dass der Kunststoff-Träger ein Polystyrol ist.

9. Vorrichtung nach einem der Ansprüche 1 bis 5, dadurch gekennzeichnet, dass der Kunststoff-Träger ein Copolymer ist, das als Hauptkomponenten Methacrylate und Styrole hat.

10. Vorrichtung nach einem der Ansprüche 1 bis 9, dadurch gekennzeichnet, dass der Zusatz aus mindestens einem monomeren oder polymeren, insbesondere hochsiedenden Alkohol besteht.

11. Vorrichtung nach Anspruch 10, dadurch gekennzeichnet, dass der Alkohol ein aliphatischer Alkohol ist.

12. Vorrichtung nach Anspruch 11, dadurch gekennzeichnet, dass der aliphatische Alkohol ein Glykol, insbesondere ein Äthylenglykol, ein Di-, Tri-, Oligo- oder ein Polyäthylenglykol ist.

13. Vorrichtung nach Anspruch 10, dadurch gekennzeichnet, dass der Alkohol ein aromatischer Alkohol, insbesondere Benzylalkohol, ist.

14. Vorrichtung nach einem der Ansprüche 1 bis 9, dadurch gekennzeichnet, dass der Zusatz ein Nitril ist.

15. Vorrichtung nach einem der Ansprüche 1 bis 9, dadurch gekennzeichnet, dass der Zusatz eine Seife ist.

16. Vorrichtung nach Anspruch 15, dadurch gekennzeichnet, dass die Seife ein Polyoxyäthylensorbitanmonolaurat ist.

17. Vorrichtung nach einem der Ansprüche 1 bis 9, dadurch gekennzeichnet, dass der Zusatz ein hochsiedendes polares Lösungsmittel ist.

18. Vorrichtung nach Anspruch 17, dadurch gekennzeichnet, dass das Lösungsmittel Phtalsäuredibutylester ist.

19. Verfahren zur Herstellung einer Vorrichtung gemäss einem der Ansprüche 1 bis 18, dadurch gekennzeichnet, dass der Zusatz mit dem zunächst monomeren Kunststoff gemischt wird und dass anschliessend der Kunststoff polymerisiert und gegebenenfalls vernetzt wird.

20. Verfahren zur Herstellung einer Vorrichtung gemäss einem der Ansprüche 1 bis 18, dadurch gekennzeichnet, dass der monomere Kunststoff zunächst zu einem Thermoplasten polymerisiert wird, dass dann der Zusatz mit dem Thermoplasten gemischt wird und dass gegebenenfalls der Thermoplast hiernach vernetzt wird.

21. Verfahren nach Anspruch 19 oder 20, dadurch gekennzeichnet, dass der mit dem Zusatz versehene Kunststoff in die Form des Fluoreszenzkörpers vergossen wird und anschliessend gegebenenfalls vernetzt wird.

22. Verfahren nach Anspruch 20, dadurch gekennzeichnet, dass die Mischung durch Spritzgiessen oder Extrudieren in die Form des Fluoreszenzkörpers gebracht wird.

23. Verfahren nach einem der Ansprüche 19 bis 22, dadurch gekennzeichnet, dass der Kunststoff mit dem Zusatz bei höheren Temperaturen gemischt und anschliessend die Mischung nach der Formgebung rasch auf niedrige Temperaturen gebracht wird.

**Patent Claims**

1. Apparatus for collecting light having a preferably plate-shaped body («fluorescence body») acting as a light-trap, which consists of a solid polymerized synthetic resin carrier containing fluorescent particles and which is provided with at least one light emergence window, characterised in that the fluorescent particles (6) have finite dipole moments which have different values in the ground state and in the excited state, and in that in the plastics carrier, there is uniformly distributed a polar organic additive which produces an environment around each fluorescent particle (6), with an orientating polarisation, this environment being capable of orientating itself so rapidly that it substantially completely reaches its thermodynamic equilibrium during the excitation state of the fluorescent particle (6).

2. Apparatus as claimed in Claim 1, characterised in that a frequency which corresponds approximately to the reciprocal of the life period of the excitation state of the fluorescent particles, the fluorescence body has a relative dielectric constant of between 5 and 20, in particular between 7 and 15.

3. Apparatus as claimed in Claim 1 or Claim 2, characterised in that the proportion by weight of the additive, in relation to the weight of the whole fluorescence body, lies between 20 and 60% by weight, in particular between 30 and 50% by weight.

4. Apparatus as claimed in one of Claims 1 to 3, characterised in that the additive is dissolved or chemically bound in the synthetic resin carrier.

5. Apparatus as claimed in one of Claims 1 to 4, characterised in that the synthetic resin carrier is cross-linked or is not cross-linked.

6. Apparatus as claimed in one of Claims 1 to 5, characterised in that the synthetic resin carrier is a polyacrylate.

7. Apparatus as claimed in one of Claims 1 to 5, characterised in that the synthetic resin carrier is a polymethacrylate.

8. Apparatus as claimed in one of Claims 1 to 5, characterised in that the synthetic resin carrier is a polystyrene.

9. Apparatus as claimed in one of Claims 1 to 5, characterised in that the synthetic resin carrier is a copolymer having, as main components, methacrylates and styrenes.

10. Apparatus as claimed in one of Claims 1 to 9, characterised in that the additive consists of at least one monomeric or polymeric alcohol, in particular a high-boiling alcohol.

11. Apparatus as claimed in Claim 10, characterised in that the alcohol is an aliphatic alcohol.

12. Apparatus as claimed in Claim 11, characterised in that the aliphatic alcohol is a glycol, in particular ethylene glycol, a diethylene glycol, a triethylene glycol, an oligoethylene glycol, or a polyethylene glycol.

13. Apparatus as claimed in Claim 10, characterised in that the alcohol is an aromatic alcohol, in particular benzyl alcohol.

14. Apparatus as claimed in one of Claims 1 to 9, characterised in that the additive is a nitrile.

15. Apparatus as claimed in one of Claims 1 to 9, characterised in that the additive is a soap.

16. Apparatus as claimed in Claim 15, characterised in that the soap is a polyoxyethylenesorbitanmonolaurate.

17. Apparatus as claimed in one of Claims 1 to 9, characterised in that the additive is a high-boiling polar solvent.

18. Apparatus as claimed in Claim 17, characterised in that the solvent is benzoe acid dibutyl phthalate.

19. A method for the production of apparatus as claimed in one of Claims 1 to 18, characterised in that the additive is mixed with the initially monomeric synthetic resin material and that the synthetic resin material is subsequently polymerized and, when required, cross-linked.

20. A method for the production of apparatus as claimed in one of Claims 1 to 18, characterised in that the monomeric synthetic resin material is first polymerized to form a thermoplastic material, that subsequently the additive is mixed with the thermoplastic material and the thermoplastic material is thereafter cross-linked, when required.

21. A method as claimed in Claim 19 or Claim 20, characterised in that the synthetic resin provided with the additive is cast into the shape of the fluorescence body and is subsequently cross-linked, when required.

22. A method as claimed in Claim 20, characterised in that the mixture is shaped to form the fluorescence body by injection moulding or extrusion.

23. A method as claimed in one of Claims 19 to 22, characterised in that the synthetic resin material is mixed with the additive at higher temperatures and that, subsequently, the mixture is rapidly brought to a low temperature after moulding.

**Revendications**

1. Dispositif collecteur de lumière comprenant un corps («corps fluorescent») servant de piège à lumière et affectant avantageusement la forme d'une plaque, qui est en un support solide en matière plastique polymérisée, qui contient des particules fluorescentes et qui est muni d'au moins une lucarne de sortie pour la lumière, caractérisé en ce que les particules (6) fluorescentes ont des moments dipolaires finis de valeur différente à l'état fondamental et à l'état excité et, dans le support en matière plastique, est réparti uniformément un additif organique polaire qui donne autour de chaque particule (6) fluorescente un entourage ayant une polarisation d'orientation, l'entourage pouvant être réorienté rapidement de manière à atteindre d'une manière pratiquement totale l'équilibre thermodynamique pendant que la particule (6) fluorescente est à l'état excité.

2. Dispositif suivant la revendication 1, caractérisé en ce que le corps fluorescent a une constante diélectrique relative comprise entre 5 et 20 et notamment entre 7 et 15 à une fréquence qui correspond à peu près à l'inverse de la durée de vie de la particule fluorescente à l'état excité.

3. Dispositif suivant la revendication 1 ou 2, caractérisé en ce que l'additif représente de 20 à 60% et notamment de 30 à 50% du poids total du corps fluorescent.

4. Dispositif suivant l'une des revendications 1 à 3, caractérisé en ce que l'additif est dissout dans le support en matière plastique ou y est fixé chimiquement.

5. Dispositif suivant l'une des revendications 1 à 4, caractérisé en ce que le support en matière plastique est réticulé ou ne l'est pas.

6. Dispositif suivant l'une des revendications 1 à 5, caractérisé en ce que le support en matière plastique est un polyacrylate.

7. Dispositif suivant l'une des revendications 1 à 5, caractérisé en ce que le support en matière plastique est un polyméthacrylate.

8. Dispositif suivant l'une des revendications 1 à 5, caractérisé en ce que le support en matière plastique est un polystyrène.

9. Dispositif suivant l'une des revendications 1 à 5, caractérisé en ce que le support en matière plastique est un copolymère, qui a le méthacrylate et le styrène comme constituants principaux.

10. Dispositif suivant l'une des revendications 1 à 9, caractérisé en ce que l'additif comprend au moins un alcool monomère ou polymère, notamment à point d'ébullition élevé.

11. Dispositif suivant la revendication 10, caractérisé en ce que l'alcool est aliphatique.

12. Dispositif suivant la revendication 11, caractérisé en ce que l'alcool aliphatique est un glycol, notamment un éthylèneglycol, un diéthylèneglycol, un triéthylèneglycol, un oligoéthylèneglycol ou un polyéthylèneglycol.

13. Dispositif suivant la revendication 10, caractérisé en ce que l'alcool est aromatique et notamment est l'alcool benzylique.

14. Dispositif suivant l'une des revendications 1 à 9, caractérisé en ce que l'additif est un nitrile.

15. Dispositif suivant l'une des revendications 1 à 9, caractérisé en ce que l'additif est un savon.

16. Dispositif suivant la revendication 15, caractérisé en ce que le savon est un poly(monolaurate d'oxyéthylène sorbitan).

17. Dispositif suivant l'une des revendications 1 à 9, caractérisé en ce que l'additif est un solvant polaire à point d'ébullition élevé.

18. Dispositif suivant la revendication 17, caractérisé en ce que le solvant est l'ester dibutylique de l'acide phtalique.

19. Procédé de fabrication d'un dispositif suivant l'une des revendications 1 à 18, caractérisé en ce qu'il consiste à mélanger l'additif à la matière plastique qui est d'abord sous forme monomère et, ensuite, à polymériser la matière plastique et, le cas échéant, à la réticuler.

20. Procédé de fabrication d'un dispositif suivant l'une des revendications 1 à 18, caractérisé en ce qu'il consiste à polymériser la matière plastique qui est d'abord sous forme monomère en un thermoplaste, à mélanger ensuite l'additif au thermoplaste et, le cas échéant, à réticuler ensuite le thermoplaste.

21. Procédé suivant la revendication 19 ou 20, caractérisé en ce qu'il consiste à couler la matière plastique additionnée de l'additif sous la forme d'un corps fluorescent et ensuite, le cas échéant, à la réticuler.

22. Procédé suivant la revendication 20, caractérisé en ce qu'il consiste à mettre le mélange sous la forme du corps fluorescent par moulage par injection ou par extrusion.

23. Procédé suivant l'une des revendications 1 à 22, caractérisé en ce qu'il consiste à mélanger la matière plastique à l'additif à des températures assez élevées et ensuite, après la mise en forme, à ramener le mélange rapidement à des températures plus basses.

FIG 1

FIG 3

FIG 2